Europäisches Patentamt

European Patent Office

Office européen des brevets

(19)

(11) **EP 1 266 449 B1**

(12) **EUROPÄISCHE PATENTSCHRIFT**

(45) Veröffentlichungstag und Bekanntmachung des Hinweises auf die Patenterteilung:
**17.09.2003 Patentblatt 2003/38**

(21) Anmeldenummer: **01919128.7**

(22) Anmeldetag: **02.02.2001**

(51) Int Cl.⁷: **H03H 9/145**

(86) Internationale Anmeldenummer:
**PCT/DE01/00408**

(87) Internationale Veröffentlichungsnummer:
**WO 01/065687 (07.09.2001 Gazette 2001/36)**

(54) **INTERDIGITALWANDLER MIT VERTEILTER ANREGUNG**

INTERDIGITAL CONVERTER WITH DISTRIBUTED EXCITATION

TRANSDUCTEUR INTERDIGITAL A EXCITATION REPARTIE

(84) Benannte Vertragsstaaten:
**DE FR**

(30) Priorität: **29.02.2000 DE 10009517**

(43) Veröffentlichungstag der Anmeldung:
**18.12.2002 Patentblatt 2002/51**

(73) Patentinhaber: **EPCOS AG**
**81669 München (DE)**

(72) Erfinder: **BERGMANN, Andreas**
**84533 Haiming (DE)**

(74) Vertreter: **Epping Hermann & Fischer**
**Ridlerstrasse 55**
**80339 München (DE)**

(56) Entgegenhaltungen:
**US-A- 4 006 438    US-A- 4 223 284**
**US-A- 4 321 567**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**Beschreibung**

Die Erfindung betrifft einen Interdigitalwandler, insbesondere für einen Oberflächenwellenfilter (OFW-Filter) zur Verwendung in einem drahtlosen Kommunikationsendgerät.

Für Sende- und Empfangsfilter drahtloser Kommunikationsendgeräte, insbesondere von Mobiltelefonen sind Filter mit einer genau definierten Übertragungsfunktion erforderlich. Insbesondere soll ein solches Filter einen ausreichend breiten Durchlaßbereich mit niedriger Einfügedämpfung und steilen Flanken aufweisen. Die Unterdrückung störender Signale außerhalb des Durchlaßbereichs, also das Selektionsverhalten soll ausreichend hoch sein.

Bei der konkreten Realisierung geeigneter Filter treten weitere Probleme auf. Die Wahl des Substratmaterials für den OFW-Filter wird üblicherweise durch den gewünschten Temperaturkoeffizienten und die Stärke der elektroakustischen Kopplung bestimmt beziehungsweise beeinflußt. Weiterhin zwingt die zunehmende Miniaturisierung zu einer Begrenzung der zur Verfügung stehenden Chipfläche. Dies wiederum hat zur Folge, daß eine gewünschte Übertragungsfunktion für den Filter auf einer begrenzten Chipfläche oft nur mittels einer bestimmten Filtertechnik realisiert werden kann. Da durch die Substratwahl auch der Kopplungsfaktor vorgegeben ist, kann auf die Impedanz des Wandlers nur noch wenig Einfluß genommen werden. Für die Schaltungsumgebung des Filters und insbesondere für einige Anwendungen ist die Wahl einer geeigneten Filterimpedanz jedoch von hoher Bedeutung. Für einen Mischer mit Open-Kollektor-Ausgang zum Beispiel hat eine zu niedrige Filterimpedanz einen erhöhten Stromverbrauch und damit in netzunabhängigen Geräten einen erhöhten Batterieverbrauch und eine kürzere Betriebsdauer zur Folge.

Zum Einstellen einer gewünschten Übertragungsfunktion ist eine Wichtung der Interdigitalwandler erforderlich. Eine Überlappungswichtung führt zu reduzierter Überlappungslänge und geht mit einer größer werdenden Beugung und damit auch mit Übertragungsverlusten einher. Bei weglaßgewichteten Wandlern werden mehrere, örtlich verteilte kleine Überlappungen - wie bei der Überlappungswichtung - nun durch Überlappungen ersetzt, deren Anregungsstärke im ganzen Wandler einheitlich ist. Dies führt allerdings zu einem Approximationsfehler, der insbesondere bei Wandlern mit großem Zeitdauer-Bandbreiteprodukt bewirkt, daß das Verhalten des weglaßgewichteten Wandlers stark von der gewünschten Übertragungsfunktion bei kontinuierlicher Wichtung abweicht.

Ein weiteres Problem ist eine hohe Güte, die zwar in Verbindung mit eng tolerierten Anpaßelementen zu einem optimalen Übertragungsverhalten führt, die dieses jedoch gegenüber Schwankungen der Anpaßelemente empfindlich macht. Insbesondere breitbandige Filter mit großer Flankensteilheit weisen eine hohe Güte auf, da bei diesen Filtern der Realteil der Wandleradmittanz klein ist.

Zur Erhöhung der Impedanz eines Wandlers auf vorgegebenen Substratmaterial kann die Apertur verringert werden. Dabei wird jedoch die Oberflächenwelle stärker gebeugt, und die erreichbare Flankensteilheit des Filters nimmt ab. Auch durch Ausnutzen unterschiedlicher Phasenbeziehungen sich überlagernder Teilwellen kann die Wandlerimpedanz eingestellt werden. Dies ist aber nicht möglich, ohne die Reflektivität von SPUDT-Zellen zu beeinflussen, welche zunehmend in Filtern eingesetzt werden. Eine weitere Möglichkeit zur Erhöhung der Impedanz eines Wandlers besteht darin, die Abtastrate zu verringern. Dies hat jedoch zur Folge, daß höhere Harmonische angeregt werden, die die Selektion im Stoppband verschlechtern. Bei weglaßgewichteten Wandlern führt eine reduzierte Abtastrate außerdem dazu, daß die gewünschte Wichtungsfunktion weniger genau approximiert wird.

Zur Verringerung des Approximationsfehlers der Weglaßwichtung kann diese mit Überlappungswichtung kombiniert werden, was jedoch wieder zu größer werdender Beugung führt. Durch Spannungswichtung, also durch kapazitive Spannungsteilung kann die Anregung ohne Verkürzung der Überlappungslänge in Teilbereichen des Wandlers reduziert werden und damit der Einfluß der Beugung verringert werden. In weglaßgewichteten Wandlern läßt sich so die Abtastrate vergrößern und der Approximationsfehler verkleinern. Allerdings erfordert die Spannungswichtung für den kapazitiven Spannungsteiler einen weiteren nur als Kapazität genutzten Wandler. Dieser benötigt jedoch zusätzliche Chipfläche und erzeugt Übertragungsverluste.

Die Frequenzcharakteristik eines Filters mit Wandlern hoher Güte kann nur mit sehr genauen und damit teuren Anpaßelementen mit geringen Toleranzwerten erzielt werden. Eine Erhöhung der Toleranz ist nur möglich, wenn die Welligkeit des Durchlaßbereichs noch kleiner und die Flankensteilheit noch größer eingestellt ist, so daß selbst bei schwankender elektrischer Anpassung die gewünschten Anforderungen noch erfüllt werden können. Dies geht jedoch stets mit einem größeren Zeitdauer-Bandbreiteprodukt einher und läßt sich nur auf vergrößerter Chipfläche realisieren.

Aufgabe der vorliegenden Erfindung ist es, einen Wandler mit dem gewünschten Übertragungsverhalten anzugeben, welcher die genannten Nachteile weitgehend vermeidet.

Diese Aufgabe wird erfindungsgemäß durch einen Interdigitalwandler nach Anspruch 1 gelöst. Vorteilhafte Ausgestaltungen der Erfindung gehen aus den Unteransprüchen hervor.

Die Erfindung geht von der an sich bekannten Idee aus, die Impedanz eines Interdigitalwandlers zumindest teilweise durch seriell geschaltete Einzelwandler zu erhöhen. Erfindungsgemäß wird diese Maßnahme nun dazu genutzt, den Interdigitalwandler in mehrere parallel geschaltete und innerhalb der akustischen Spur nebeneinander angeordnete Teilwandler aufzuteilen, und diese Teilwandler durch seriell verschaltete Serienteilwandler zu ersetzen. Die Aufteilung in Serienteilwandler über den gesamten Interdigitalwandler ist unterschiedlich, so daß die Spurbreiten der Serienteilwandler von einem Teilwandler zum anderen variieren. Auf diese Weise gelingt es, Serienteilwandler mit unterschiedlicher Spannung und damit unterschiedlicher Anregungsstärke in einer gewünschten Weise über den Interdigitalwandler zu verteilen und gleichzeitig dessen Gesamtimpedanz zu erhöhen.

Die Impedanz eines (Teil-)Wandlers kann dabei um den Faktor $n^2$ erhöht werden, wenn dieser (in Transversalrichtung) in n Serienteilwandler der normierten Apertur $1/n$ aufgeteilt ist und diese Teilwandler elektrisch in Serie geschaltet werden. Diese Aufteilung kann durch elektrisch nicht angeschlossene und daher floatende Elektrodenkämme erfolgen, die Überlappungen mit dem jeweils benachbarten Elektrodenkamm aufweisen. Da für eine Anzahl n von Serienteilwandlern n - 1 zusätzliche Elektrodenkämme erforderlich sind, ist es bei geradzahligen n und symmetrischem Betrieb auch möglich, den mittleren dieser zusätzlichen Wandlerkämme auf Massepotential zu legen und den Wandler damit symmetrisch zu betreiben.

Das transversale Profil der angeregten Welle und somit die Impulsantwort des Wandlers bleiben bei einer gleichmäßigen Aufteilung unverändert, wenn man von den zusätzlichen transversalen Gaps und den Verbindungsstegen der Elektrodenkämme absieht, die nicht überlappen können und daher nicht zur Anregung beitragen.

Bei einer Aufteilung eines Wandlers in unterschiedliche seriell verschaltete Serienteilwandler läßt sich die Impulsantwort des Wandlers gezielt beeinflussen. Da die Anregungsstärke proportional zur anliegenden Spannung ist und diese mit abnehmender Apertur bzw. abnehmendem Abstand der beiden Stromschienen bzw. Elektrodenkämme ansteigt, wird in Serienteilwandlern mit größerer Apertur eine geringere Anregung pro Überlappung erzielt als in Serienteilwandlern mit kleinerer Apertur. Bei vergleichbaren Fingeranordnungen ist die Apertur proportional zur Spurbreite eines Serienteilwandlers.

Die Aufteilung in Serienteilwandler kann dann dabei so erfolgen, daß sämtliche Serienteilwandler eines Teilwandlers die gleiche Länge haben. Entsprechend kann auch die Aufteilung des gesamten Interdigitalwandlers in Teilwandler so erfolgen, daß sämtliche Teilwandler die gleiche Länge aufweisen.

Möglich ist es jedoch auch,- daß innerhalb eines Teilwandlers die innenliegenden Elektrodenkämme unterschiedlich lang ausgebildet sind.

In einer weiteren Ausgestaltung der Erfindung weist der Interdigitalwandler zwei Gruppen jeweils parallel geschalteter Teilwandler auf, wobei die Gruppen seriell verschaltet sind. Dies läßt sich beispielsweise erreichen, indem eine äußere Stromsammelschiene aufgeteilt wird in Teilsammelschienen und in dem an diese unterschiedliches Potential angelegt wird. Dabei kann die Aufteilung in seriell geschaltete Gruppen von Teilwandlern symmetrisch erfolgen, so daß der Interdigitalwandler eine zwischen den beiden Teilsammelschienen liegende Symmetrieachse aufweist.

Auch ohne aufgetrennte Stromsammelschiene kann der Interdigitalwandler symmetrisch aufgebaut sein. Der Aufbau erfolgt dabei vorzugsweise so, daß innenliegende Teilwandler die größte Anregungsstärke aufweisen. Dies wird erreicht, indem innen und vorzugsweise in der Mitte des Interdigitalwandlers liegende Teilwandler die geringste Anzahl an zusätzlichen Elektrodenkämmen und damit an in Serie geschalteten Serienteilwandlern aufweisen, oder bei denen alternativ innen und vorzugsweise in der Mitte des Interdigitalwandlers liegende Teilwandler in Serienteilwandler gleicher oder zumindest ähnlicher Spurbreite aufgeteilt ist und bei dem für außenliegende Teilwandler gilt, daß sich die Spurbreiten deren Serienteilwandler stärker unterscheiden als die innenliegenden Teilwandler. Für nicht in der Mitte des Interdigitalwandlers liegenden Teilwandler gilt vorzugsweise, daß die inneren Serienteilwandler die größte Spurbreite aufweisen. Vorzugsweise ist die Spurbreitenverteilung der Serienteilwandler symmetrisch zu einer in longitudinaler Richtung liegenden Symmetrieachse.

Die Serienverschaltung von Serienteilwandlern hat weiterhin zur Folge, daß deren Gesamtkapazität reduziert wird. Wird beispielsweise ein Wandler mit einer statischen Kapazität pro Längeneinheit $C_1$ durch die Serienverschaltung zweier Wandler ersetzt, an denen jeweils die halbe Gesamtspannung anliegt, sinkt die statische Kapazität pro Längeneinheit auf einen Wert $C_{1s} = C_1/4$. Somit hat also jede Aufteilung eines Wandlers in seriell verschaltete Teilwändler zur Folge, daß sich bei gleichbleibender Gesamtapertur bzw. Spurbreite und gleicher Fingeranschlußfolge die statische Kapazität reduziert. Da statische Kapazität wesentlich für die Güte eines Wandlers verantwortlich ist, wird dadurch auch die Güte reduziert. Damit ergibt sich ein höherer Toleranzbereich für die Anpaßelemente eines Filters mit einem erfindungsgemäßen Interdigitalwandler.

Im folgenden wird die Erfindung anhand von Ausführungsbeispielen und der dazugehörigen Figuren näher erläutert.

Figur 1      zeigt einen erfindungsgemäßen Interdigitalwandler mit drei Teilwandlern

Figuren 2 und 3      zeigen zwei weitere Möglichkeiten der Aufteilung eines Interdigitalwandlers in Teilwandler mit Serienteilwandlern

Figuren 4 bis 6      zeigen verschiedene Strukturen für Teilwandler beziehungsweise Serienteilwandler

Figur 7        zeigt die Seriellverschaltung zweier Gruppen von parallel verschalteten Teilwandlern mit seriell verschalteten Serienteilwandlern

Die schematischen Figuren dienen nur dem besseren Verständnis der Erfindung und sind daher weder mit einheitlichem Maßstab noch maßstabsgetreu dargestellt.

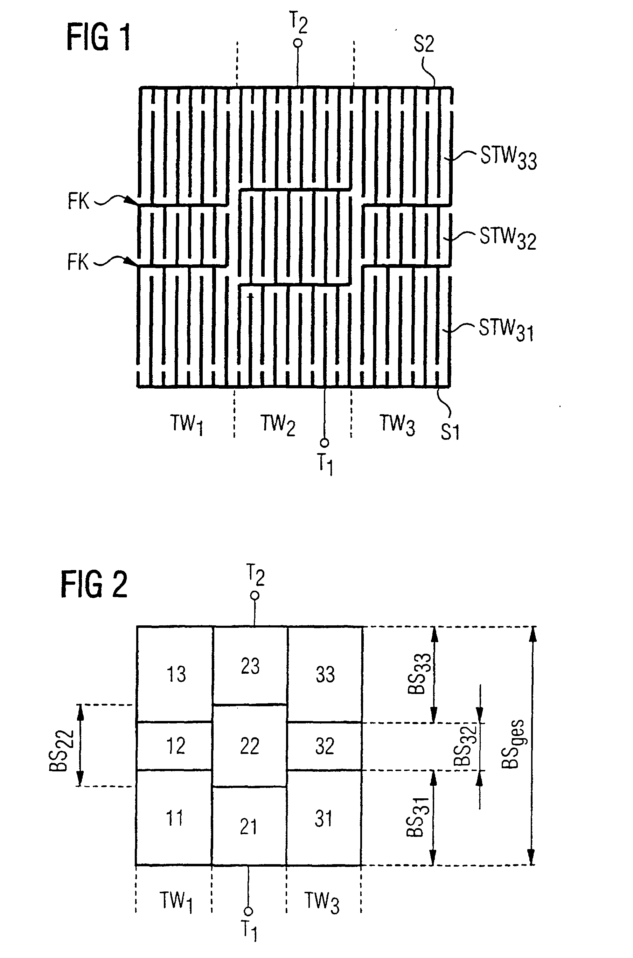

Figur 1 zeigt einen ersten erfindungsgemäßen Interdigitalwandler, bestehend aus drei zwischen zwei Stromschienen S1 und S2 parallel verschalteten Teilwandlern TW1 bis TW3. Jeder Teilwandler $TW_x$ wiederum besteht aus drei seriell verschalteten Serienteilwandlern $STW_{x1}$ bis $STW_{x3}$. Die Aufteilung der Teilwandler $TW_x$ in Serienteilwandler $STW_{xi}$ erfolgt durch Zwischenanordnung floatenden Elektrodenkämmen FK, deren Elektrodenkämme mit dem oder den Elektrodenfingern der benachbarten Stromsammelschiene S oder des benachbarten Elektrodenkamms FK überlappen. Die Anschlüsse des erfindungsgemäßen Interdigitalwandlers sind mit T1 und T2 bezeichnet.

In Figur 2 ist die Aufteilung des Interdigitalwandlers in Teilwandler und in Serienteilwandler nochmals schematisch dargestellt, wobei in den für die Serienteilwandler stehenden Kästchen nur die Indizes entsprechenden Serienteilwandler als Bezeichnung eingetragen sind. In diesem Ausführungsbeispiel ist der mittlere Teilwandler TW2 in drei gleich große Serienteilwandler mit den Indizes 21, 22 und 23 unterteilt. Dies hat zunächst zur Folge, daß die Impedanz dieses Teilwandlers TW2 das 9-fache der Impedanz eines ungeteilten Wandlers der gleichen Länge und der gleichen Spurbreite BS aufweist. Durch die symmetrische Aufteilung liegt an jedem Serienteilwandler STW die gleiche Spannung an, die in diesem Fall für jeden Serienteilwandler 1/3 der Gesamtspannung des Teilwandlers TW2 ausmacht. Der Teilwandler TW2 hat eine Gesamtanregungsstärke, die 1/3 der Anregungsstärke beträgt, die ein unceteilter Wandler der vollen Spurbreite $BS_{ges}$ aufweisen würde.

Die beiden äußeren Teilwandler TW1 und TW3 weisen beide die gleiche Aufteilung in Serienteilwandler STW auf. Die Spurbreiten der Serienteilwandler mit den Indizes 11, 12 und 13 verhalten sich wie 2:1:2. Ein entsprechendes Verhältnis weisen auch die Teilkapazitäten $C_{xi}$ auf, für die Teilwandler TW1 und TW3 also 2:1:2. Für das Verhältnis der Spannungen, die an den Serienteilwandlern anliegen, ergibt sich annähernd das umgekehrte Verhältnis, nämlich 1:2:1 für die Serienteilwandler der Teilwandler TW1 und TW3. Bei dieser Aufteilung ergibt es sich, daß hier allen Serienteilwandlern STW der Teilwandler TW1 und TW3 die gleiche Anregungsstärke zukommt, die hier jeweils 1/10 der Anregungsstärke beträgt, die ein Teilwandler mit der Spurbreite $BS_{ges}$ aufweisen würde. Damit ergibt sich als Gesamtanregung für die Teilwandler TW1 und TW3 3/10, für den Teilwandler TW2 dagegen 1/3 der Anregungsstärke eines ungeteilten Wandlers der vollen Spurbreite $ES_{ges}$.

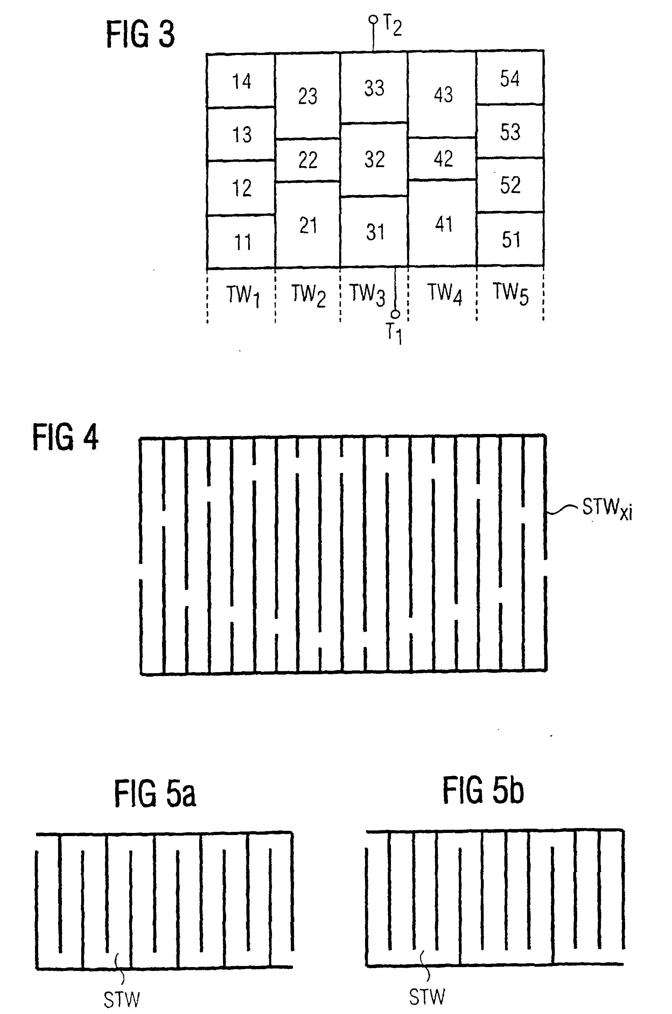

Figur 3 zeigt in schematischer Darstellung die Aufteilung eines erfindungsgemäßen Interdigitalwandlers in insgesamt fünf Teilwandler $TW_x$, die jeweils in drei oder vier Serienteilwandler $STW_{xi}$ aufgeteilt sind. Auch hier ist wieder eine symmetrische Aufteilung gewählt, wobei dem mittleren Teilwandler TW3 die größte Anregungsstärke zukommt, den äußeren Teilwandlern TW1 und TW5 dagegen die geringste. Die relative Anregungsstärke der Serienteilwandler der Teilwandler TW2 und TW4 beträgt jeweils ungefähr 2/27 der Anregung eines ungeteilten Wandlers der Spurbreite $BS_{ges}$. Bei relativen Spurbreitenverhältnissen von 4:1:4 ergibt sich für die Serienteilwandler der Teilwandler TW2 und TW4 ein Spannungsverhältnis von 1:4:1. Bei dieser Aufteilung kommt also jedem Serienteilwandler $STW_{xi}$ innerhalb eines Teilwandlers $TW_x$ die gleiche Anregungsstärke zu. Über den jeweiligen Teilwandler integriert ergeben sich Anregungen der Teilwandler relativ zur maximal möglichen von 3/9 (TW3), 2/9 (TW2 oder TW4) und ¼ (TW1 und TW5).

In einer weiteren Ausgestaltung der Erfindung werden die floatenden Elektrodenkämme FK der äußeren Teilwandler so verschoben, daß die mittleren Serienteilwandler innerhalb dieser Teilwandler jeweils die geringste Spurbreite aufweisen. Diesen kommt dann der größte Spannungsabfall und damit die größte relative Anregungsstärke zu. Für die über die gesamte Spurbreite $BS_{ges}$.der Teilwandler integrierte Anregungsstärke ergibt eine ungleichmäßige Aufteilung in Serienteilwandler jedoch eine geringere Gesamtanregung.

Figur 4 gibt schematisch einen gewichteten Serienteilwandler an, wie er Teil eines erfindungsgemäßen Interdigitalwandlers sein kann. Der Serienteilwandler weist eine Überlappwichtung mit den größten Gewichten in der Mitte und den kleinsten am Rand des Serienteilwandlers auf.

Figur 5a zeigt einen ungewichteten Serienteilwandler mit Normalfingeranordnung, während 5b einen Serienteilwandler mit Weglaßwichtung zeigt. Gegenüber der Anordnung von Figur 5a ist dabei jeder zweite Finger einer Stromschiene umgeklappt und der jeweils gegenüberliegenden Stromschiene zugeordnet, so daß er nicht zur Überlappung beiträgt. Mit dieser Maßnahme reduziert sich die Kapazität des in Figur 5b dargestellten Serienteilwandlers auf den halben Wert derjenigen von Figur 5a.

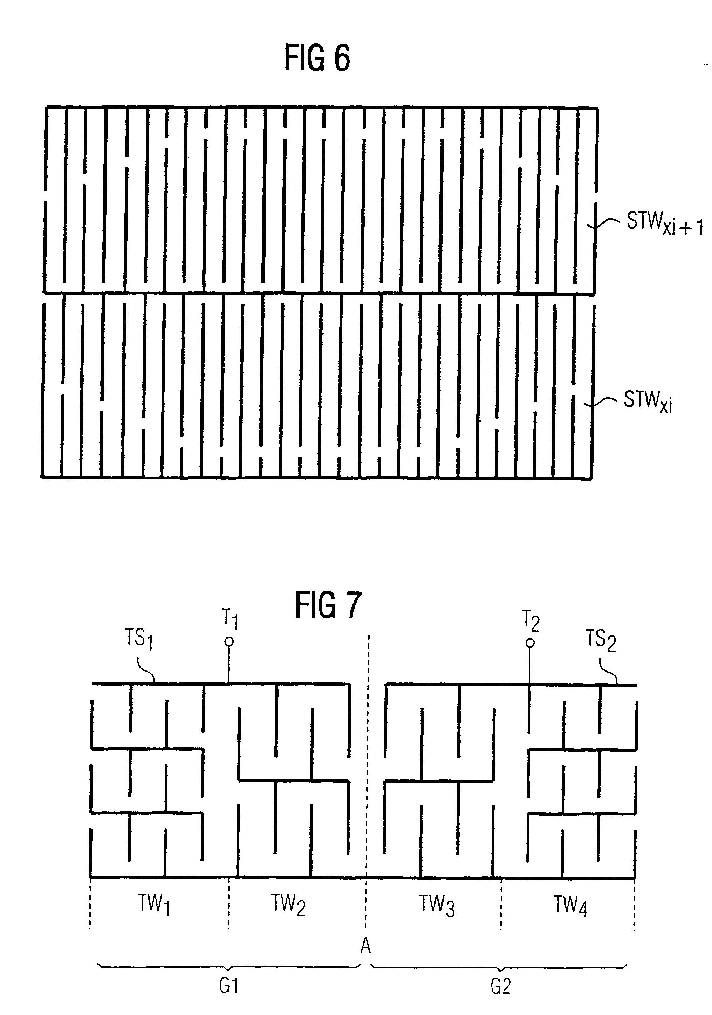

Figur 6 zeigt eine Möglichkeit, eine gewünschte Wichtung verteilt über zwei benachbarte Serienteilwandler $STW_{xi}$ und $STW_{xi+1}$ darzustellen. Als Wichtungsmethode ist die Überlappwichtung gewählt, wobei auch hier in der Mitte des Serienteilwandlers die größten Gewichte angeordnet sind, an den Rändern der Serienteilwandler dagegen die geringsten.

Figur 7 zeigt einen weiteren erfindungsgemäßen Interdigitalwandler, bei dem zwei Gruppen G1 und G2 von jeweils zwei parallel geschalteten Teilwandlern in Serie geschaltet sind. Dies wird erreicht durch Aufteilung einer Stromschiene in Teilstromschienen TS1 und TS2 und symmetrischer Anordnung der Teilwandler und der Serienteilwandler in Bezug auf eine zwischen den beiden Teilstromschienen TS1, TS2 verlaufende Symmetrieachse A. Durch die Serienverschaltung erhöht sich die Impedanz des Interdigitalwandlers um den Faktor 8 gegenüber einem Interdigitalwandler, bei dem die beiden Gruppen G1 und G2 von Teilwandlern parallel zueinander geschaltet sind.

Die Ausführungsbeispiele können nur exemplarische Möglichkeiten angeben, wie die Erfindung ausgeführt werden kann. Die Erfindung ist daher nicht auf diese beschränkt. Im Rahmen der Erfindung liegt es, einen Interdigitalwandler in eine größere Anzahl von Teilwandlern aufzuteilen. Auch die Anzahl der Serienteilwandler pro Teilwandler ist variabel, ebenso wie die relative Spurbreite der Serienteilwandler zueinander innerhalb eines Teilwandlers. Damit ist es möglich, die Anregung in einer gewünschten Weise über den Interdigitalwandler zu verteilen, die Impedanz beliebig einzustellen und gleichzeitig eine Anregungsfunktion nachzubilden, die dem Wandler beziehungsweise einem Filter mit diesem Interdigitalwandler ein gewünschtes Übertragungsverhalten garantiert. Da mit dem erfindungsgemäßen Interdigitalwandler auch die Impedanz erhöht und die Güte des Wandlers erniedrigt werden kann, werden damit gleichzeitig die Nachteile der Eingangs genannten bekannten Lösungen vermieden. Damit gelingt es auch, die benötigte Chipfläche für einen Interdigitalwandler und damit auch für ein Filter weiter zu reduzieren, ohne die Eigenschaften zu verschlechtern.

**Patentansprüche**

1. Interdigitalwandler für ein Oberflächenwellen-Bauelement,

   - mit einer akustischen Spur der Breite $BS_{ges}$
   - bei dem in einer akustischen Spur m nebeneinander angeordnete Teilwandler $TW_x$ mit x = 1, 2, ....m und m $\geq$ 2 parallel verschaltet sind,
   - bei dem die Teilwandler TW in transversaler Richtung n seriell verschaltete Serienteilwandler $STW_{xi}$ der Spurbreite $BS_{xi}$ (i = 1, 2, ....n(x); n(x) $\geq$ 2) umfassen,
   - bei dem gilt:

$$BS_{ges} = \sum_{i}^{i \cdot n} BS_{xi}$$

   und

$BS_{xi}$ ungleich $BS_{(x+1)i}$.

2. Interdigitalwandler nach Anspruch 1, bei dem für zwei Teilwandler ($TW_x$) gilt: n(x) ungleich n(x+1).

3. Interdigitalwandler nach Anspruch 1 oder 2, bei dem die Serienteilwandler ($STW_{xi}$) eines Teilwandlers ($TW_x$) durch floatende Elektrodenkämme (FK) voneinander getrennt sind.

4. Interdigitalwandler nach einem der Ansprüche 1 - 3, bei dem die seriell verschalteten Serienteilwandler ($STW_{xi}$) eines Teilwandlers (TW) jeweils die gleiche Länge haben

5. Interdigitalwandler nach Anspruch 3 oder 4, bei dem die floatenden Elektrodenkämme (FK) eines Teilwandlers (TW) unterschiedlich lang sind.

6. Interdigitalwandler nach einem der Ansprüche 1-5, bei dem eine erste Gruppe (G1) parallel geschalteter Teilwandler (TW) mit einer zweiten Gruppe (G2) von parallel geschalteten in der gleichen Spur angeordneten Teilwandlern in Serie geschaltet ist.

7. Interdigitalwandler nach Anspruch 6, bei dem die Serienverschaltung der beiden Gruppen von Teilwandlern (TW) durch Aufteilen einer der die Spur begrenzenden äußeren Stromschienen (S) in zwei oder mehr Teilschienen (TS1,TS2) erfolgt, wobei unterschiedliche Teilschienen mit den Anschlüssen (T1,T2) des Interdigitalwandlers verbunden sind.

8. Interdigitalwandler nach Anspruch 7, der gegenüber einer die akustische Spur transversal zwischen den beiden Teilschienen (TS) schneidenden Symmetrieachse (A) symmetrisch aufgebaut ist.

9. Interdigitalwandler nach einem der Ansprüche 1-8, aufgebaut als rekursiver Wandler mit verteilter Reflexion.

10. Interdigitalwandler nach einem der Ansprüche 1-8, aufgebaut als Splitfingerwandler.

11. Interdigitalwandler nach einem der Ansprüche 1-10, bei dem zumindest ein Teil der Serienteilwandler (STW). eine zusätzliche Weglasswichtung aufweist.

12. Interdigitalwandler nach einem der Ansprüche 1-11, bei dem zumindest ein Teil der Serienteilwandler (STW) eine zusätzliche Überlappwichtung aufweist.

13. Interdigitalwandler nach einem der Ansprüche 1-12, welcher eine bezüglich einer Symmetrieachse eine symmetrische Aufteilung in Teilwandler und Serienteilwandler aufweist.

**14.** Interdigitalwandler nach einem der Ansprüche 1-13, bei dem die Anregung in der Mitte des Interdigitalwandlers am größten, an den Rändern dagegen am geringsten ist.

**15.** Interdigitalwandler nach Anspruch 14, bei dem in longitudinaler Richtung innen liegende Teilwandler (TW) gleichmäßiger in Serienteilwandler aufgeteilt sind als außenliegende Teilwandler, so daß Produkt

$$\prod_i BS_{xi}$$

der Spurbreiten eines Teilwandlers ($TW_x$) für innenliegende Teilwandler mit m > x > 1 am größten und für außen liegende Teilwandler ($TW_x$) mit x = 1 oder m am kleinsten ist.

**16.** Interdigitalwandler nach Anspruch 15, bei dem in außen liegenden Teilwandlern ($TW_x$; x = 1 oder m) ein innerer Serienteilwandler ($STW_{xi}$), für den gilt n > i > 1 die kleinste Spurbreite ($BS_{xi}$) aufweist.

**17.** Verwendung eines Interdigitalwandlers nach einem der Ansprüche 1-16 für Oberflächenwellenfilter mit optimierter Anregung.

**Claims**

**1.** Interdigital converter for a surface acoustic wave component,

- having an acoustic track of width $BS_{tot}$
- in which m converter elements $TW_x$, where x = 1, 2, .... m and m $\geq$ 2, which are arranged alongside one another are connected in parallel in an acoustic track,
- in which the converter elements TW in transverse direction comprise n series-connected series converter elements $STW_{xi}$ with a track width $BS_{xi}$ (i = 1, 2, ....n(x); n(x) $\geq$ 2),
- for which

$$BS_{tot} = \sum_i^{1 \cdot n} BS_{xi}$$

and

$BS_{xi}$ is not equal to $BS_{(x+1)i}$.

**2.** Interdigital converter according to Claim 1, in which, for two converter elements ($TW_x$): n(x) is not equal to n (x+1).

**3.** Interdigital converter according to Claim 1 or 2, in which the series converter elements ($STW_{xi}$) of a converter element ($TW_x$) are separated from one another by floating electrode combs (FK).

**4.** Interdigital converter according to one of Claims 1-3, in which the series-connected series converter elements ($STW_{xi}$) of a converter element (TW) each have the same length.

**5.** Interdigital converter according to Claim 3 or 4, in which the floating electrode combs (FK) of a converter element (TW) have different lengths.

**6.** Interdigital converter according to one of Claims 1-5, in which a first group (G1) of parallel-connected converter elements (TW) are connected in series with a second group (G2) of parallel-connected converter elements which are arranged in the same track.

**7.** Interdigital converter according to Claim 6, in which the series circuit for the two groups of converter elements (TW) is produced by subdividing one of the outer busbars (S) which bound the track into two or more busbar elements (TS1, TS2), with different busbar elements being connected to the connections (T1, T2) of the interdigital converter.

**8.** Interdigital converter according to Claim 7, which is constructed to be symmetrical with respect to an axis of symmetry (A) which intersects the acoustic track transversely between the two busbar elements (TS).

**9.** Interdigital converter according to one of Claims 1-8, in the form of a recursive converter with distributed reflection.

**10.** Interdigital converter according to one of Claims 1-8, in the form of a split finger converter.

**11.** Interdigital converter according to one of Claims 1-10, in which at least some of the series converter elements (STW) have additional omission weighting.

**12.** Interdigital converter according to one of Claims 1-11, in which at least some of the series converter elements (STW) have additional overlap weighting.

**13.** Interdigital converter according to one of Claims 1-12,

which is subdivided into converter elements and series converter elements symmetrically with respect to an axis of symmetry.

14. Interdigital converter according to one of Claims 1-13,
    in which the excitation is at its greatest in the centre of the interdigital converter, and in contrast is at its lowest at the edges.

15. Interdigital converter according to Claim 14,
    in which converter elements (TW) which are located on the inside in the longitudinal direction are subdivided more uniformly into series converter elements than converter elements which are located on the outside, so that the product

$$\prod_i BS_{xi}$$

of the track widths of a converter element ($TW_x$) is at its greatest for converter elements which are located on the inside, with ($m > x > 1$, and is at its least for converter elements ($TW_x$) which are located on the outside, with $x = 1$ or m.

16. Interdigital converter according to Claim 15,
    in which an inner series converter element ($STW_{xi}$) for which $n > i > 1$ has the smallest track width ($BS_{xi}$) [lacuna] in converter elements ($TW_x$; $x = 1$ or m) which are located on the outside.

17. Use of an interdigital converter according to one of Claims 1-16 for surface acoustic wave filters with optimized excitation.


**Revendications**

1. Transducteur interdigité pour un composant à ondes de surface,

   - comprenant une piste acoustique de largeur $BS_{ges}$
   - dans lequel, dans une piste acoustique, sont montés en parallèle m sous-transducteurs $TW_x$ disposés côte-à-côte avec $x = 1, 2, 3...m$ et $m \geq 2$,
   - dans lequel les sous-transducteurs TW comprennent en direction transversale n sous-transducteurs $STW_{xi}$ série, montés en série de largeur de piste $BS_{xi}$ ($i = 1, 2.....n$ (x) ; $n(x) \geq 2$),

$$BS_{ges}= \sum^{i-n} BS_{xi}$$

et

$Bs_{xi}$ different de $BS_{(x+1)i}$.

2. Transducteur interdigité suivant la revendication 1, dans lequel on a pour deux sous-transducteurs ($TW_x$) n (x) différent de n (x + 1).

3. Transducteur suivant la revendication 1 ou 2, dans lequel les sous-transducteurs ($STW_{xi}$) série d'un sous-transducteur ($TW_x$) sont séparés les uns des autres par des peignes (FK) flottants d'électrodes.

4. Transducteur interdigité suivant l'une des revendications 1 à 3 dans lequel les sous-transducteurs ($STW_{xi}$) série montés en série d'un sous-transducteur (TW) ont respectivement la même longueur.

5. Transducteur interdigité suivant la revendication 3 ou 4 dans lequel les peignes (FK) flottants d'électrodes d'un sous-transducteur (TW) sont de longueur différente.

6. Transducteur interdigité suivant l'une des revendications 1 à 5, dans lequel un premier groupe (G1) de sous-transducteurs (TW) montés en parallèle est monté en série avec un deuxième groupe (G2) de sous-transducteurs montés en parallèle et disposés dans la même piste.

7. Transducteur interdigité suivant la revendication 6 dans lequel on effectue le montage série des deux groupes de sous-transducteurs (TW) par subdivision d'un rail (S) extérieur de courant délimitant la piste en deux ou en plusieurs sous-rails (TS1, TS2), des sous-rails différents étant reliés aux bornes (T1, T2) du transducteur interdigité.

8. Transducteur interdigité suivant la revendication 7, qui est symétrique par rapport à un axe (A) de symétrie coupant transversalement la piste acoustique entre les deux sous-rails (TS).

9. Transducteur interdigité suivant l'une des revendications 1 à 8 constitué sous la forme d'un transducteur récursif à réflexion répartie.

10. Transducteur interdigité suivant l'une des revendications 1 à 8, constitué sous la forme d'un transducteur à doigt fendu.

11. Transducteur interdigité suivant l'une des revendications 1 à 10, dans lequel au moins une partie des sous-transducteurs (STW) série a une pondération supplémentaire de suppression.

12. Transducteur interdigité suivant l'une des revendications 1 à 11, dans lequel au moins une partie des sous-transducteurs (STW) série a une pondération de chevauchement supplémentaire.

**13.** Transducteur interdigité suivant l'une des revendications 1 à 12, qui a une répartition symétrique en sous-transducteurs et en sous-transducteurs série par rapport à un axe de symétrie.

**14.** Transducteur interdigité suivant l'une des revendications 1 à 13, dans lequel l'excitation est la plus grande au milieu du transducteur interdigité alors qu'elle est la plus petite au bord.

**15.** Transducteur interdigité suivant la revendication 14, dans lequel des sous-transducteurs (TW) intérieurs en direction longitudinale, sont répartis d'une manière plus uniforme en sous-transducteurs série que les sous-transducteurs extérieurs de sorte que le produit $\Pi BS_{xi}$ des largeurs de piste d'un sous-transducteur ($TW_x$) est le plus grand pour des sous-transducteurs intérieurs avec $m > x > 1$ et est le plus petit pour des sous-transducteurs ($TW_x$) extérieurs avec $x = 1$ ou m.

**16.** Transducteur interdigité suivant la revendication 15, dans lequel, dans les sous-transducteurs ($TW_x$ ; $x = 1$ ou m) extérieurs, un sous-transducteur ($STW_{xi}$) série intérieur pour lequel $n > i > 1$ a la largeur ($Bs_{xi}$) de piste la plus petite.

**17.** Utilisation d'un transducteur interdigité suivant l'une des revendications 1 à 16, pour des filtres d'ondes de surface à excitation optimisée.

## FIG 1

T2

S2

FK

FK

STW33

STW32

STW31

TW1    TW2    TW3    S1

T1

## FIG 2

T2

| 13 | 23 | 33 |
| 12 | 22 | 32 |
| 11 | 21 | 31 |

BS22

BS33

BS32

BS31

BSges

TW1    TW3

T1

## FIG 3

| | | | | |
|---|---|---|---|---|
| 14 | 23 | 33 | 43 | 54 |
| 13 | | | | 53 |
| 12 | 22 | 32 | 42 | 52 |
| 11 | 21 | 31 | 41 | 51 |

T$_2$

T$_1$

TW$_1$  TW$_2$  TW$_3$  TW$_4$  TW$_5$

## FIG 4

STW$_{xi}$

## FIG 5a

STW

## FIG 5b

STW

## FIG 6

STW$_{xi+1}$

STW$_{xi}$

## FIG 7

T$_1$     T$_2$

TS$_1$     TS$_2$

TW$_1$   TW$_2$   TW$_3$   TW$_4$

A

G1     G2